# EUROPEAN PATENT APPLICATION

(11) **EP 2 039 657 A1**
(43) Date of publication of application: **25.03.2009**
(21) Application number: 08016492.4
(22) Date of filing: 18.09.2008
(51) Int. Cl.: C02F 1/52, C02F 1/66, C02F 1/44, B01D 71/26

(54) **Hydrofluoric acid treatment apparatus**

(30) Priority: 21.09.2007 JP 2007244964
(71) Applicant: Sanyo Electric Co., Ltd., Moriguchi-city Osaka (JP)
(72) Inventor: Sumida, Yasuteru, Ora-gun, Gunma, 370-0535 (JP); Kasahara, Tatsumi, Fukaya-City Saitama, 369-1101 (JP); Motegi, Kazutoshi, Ota-City Gunma, 373-0027 (JP); Umezawa, Hiriyuki, Ota-City Gunma, 373-0806 (JP); Kuwai, Yasuyuki, Ora-gun Gunma, 370-0513 (JP)
(74) Representative: Glawe, Delfs, Moll

(57) **Abstract**

An apparatus for the treatment of semiconductor processing wastewater containing hydrofluoric acid. Hydrofluoric acid is introduced into a treatment tank (11A) in a pH adjustment unit (10) and an alkali chemical is introduced to adjust pH to be between 8 and 10. Neutralized wastewater is introduced to a reaction tank (11B) for reaction with calcium in order to form calcium fluoride which is further separated from the treated wastewater (11C). As the pH meter (14) is provided in a circulating path (P3) in the pH adjustment unit (10) and never comes into direct contact with the acidic wastewater, the pH meter (14) is protected from being damaged by high concentration of hydrofluoric acid.

## Description

### Field of the Invention:

The present invention relates to a hydrofluoric acid treatment apparatus for separating calcium fluoride from hydrofluoric-acid-containing wastewater, and more particularly relates to a miniaturized hydrofluoric acid treatment apparatus that can be disposed close to a semiconductor processing apparatus in a clean room.

### Description of the Related Art:

From the ecological point of view, it is currently an important theme and urgent industrial task to reduce industrial waste and to sort out and recycle the industrial waste. This industrial waste includes various fluids containing substances to be removed.

These fluids are expressed by various terms such as sewage, effluent and wastewater. In the following description, the fluid such as water and chemicals containing the substance to be removed will be hereinafter referred to as wastewater.

A large amount of wastewater is generated in the middle of a semiconductor device manufacturing process. Almost an entire amount of fluorine used in a semiconductor plant is discharged as the wastewater that is difficult to recycle. For example, a dry (plasma) etching apparatus or a plasma CVD apparatus often uses fluorinated gases such as carbon tetrafluoride (CF₄), hexafluoroethane (C₂F₆) and perfluorocyclobutane (C₄F₈) for wafer processing or cleaning inside the apparatus (chamber). Most of the gases described above are discharged as CF₄ to outside the chamber. However, since those gases contain a global warming accelerating substance (Perfluorocompounds (PFCs) gas), detoxification treatment is required. In this detoxification treatment, fluorine is absorbed by water and thus dilute hydrofluoric acid wastewater (effluent) is discharged. Moreover, a wet etching apparatus using a fluorinated material (for example, hydrofluoric acid) discharges thick hydrofluoric acid wastewater (effluent) that is a waste chemical after wafer processing or dilute hydrofluoric acid wastewater (effluent) that is wastewater after pure water rinse.

It has been known that, when the wastewater containing high concentrations of fluorine flows out into nature, the balance of the ecosystem is disturbed. Therefore, it is industrially very important to remove fluorine from the wastewater. For example, as effluent conditions for the wastewater containing fluorine, a standard value is determined by Water Pollution Prevention Law, regulations set by local governments, and the like. Specifically, the concentration of fluorine contained in the wastewater is required to be not more than 8 mg/L. Furthermore, the total amount of fluorine to be discharged may be controlled.

Meanwhile, the fluorine removed from the wastewater can be reused in the semiconductor processing apparatus as described above by turning the fluorine into hydrofluoric acid or the like. As an example of a removal method, fluorine can be removed from the wastewater by generating calcium fluoride from reaction between the wastewater (effluent) containing fluorine and calcium compounds (precipitation). Moreover, similarly, as a method for obtaining calcium fluoride, there has also been known a method for depositing calcium fluoride on solid particles by introducing the wastewater containing fluorine together with a calcium preparation (crystallization). This technology is described for instance in Japanese Patent Application Publication No. 2005-21855.

Meanwhile, a facility for treating hydrofluoric-acid-containing wastewater is so large that, to undergo the wastewater treatment, the wastewater needs to be stored in a tank or the like firstly, and then be transported to the wastewater treatment facility outside a clean room, for example.

In other words, although the wastewater can be reused in the semiconductor processing apparatus by treating the wastewater and producing hydrofluoric acid, the treatment facility for the hydrofluoric-acid-containing wastewater cannot be installed in the existing clean room. Thus, it is a current situation that the wastewater treatment cannot be completed inside the clean room.

In the treatment of the hydrofluoric-acid-containing wastewater, in the above example, in order to form a high-purity calcium fluoride pellet by crystallization, the wastewater (effluent) containing fluorine is neutralized by a pH adjustor. Thereafter, while the hydrofluoric acid is being reacted with calcium, pH of treated water in a reaction tank is measured, thereby adjusting a pH value within a desired range.

Therefore, it is required to increase the pH value before reaction with calcium. In order to obtain calcium fluoride by reacting the hydrofluoric acid with calcium, it is required to dissociate the hydrofluoric acid to obtain fluoride ions (F⁻). However, proportions of the hydrofluoric acid and the fluoride ions depend on the pH. Specifically, when the treated water is acidic in reaction with calcium, the hydrofluoric acid takes up a major proportion. Thus, there is a problem that treatment efficiency is deteriorated.

Meanwhile, for example, considered is the case where a pH meter is installed in a neutralization tank to measure a pH value in the neutralization tank in which the wastewater containing fluorine and the pH adjustor are mixed with each other. Since the pH meter generally uses a glass electrode, glass is melted in such a case as where the concentration of the wastewater containing fluorine is very high, for example. Thus, there is a problem that melting of glass damages a sensor.

It is an object of the invention to provide an improved treatment apparatus that lessens this drawback.

### SUMMARY OF THE INVENTION

The solution according to the invention resides in the features of the independent claim and preferably in those of the dependent claims. The invention provides a hydrofluoric acid treatment apparatus which is disposed close to a semiconductor processing apparatus using a fluorinated material in a clean room and which treats hydrofluoric acid-containing wastewater discharged from the semiconductor processing apparatus without carrying the wastewater out of the clean room. The apparatus includes: a pH adjustment unit which includes a treatment tank, first and second paths connected to the treatment tank and a third path provided in the treatment tank so as to have a circulating structure, which generates a first treated water having a pH value larger than that of the wastewater by introducing an alkali chemical through the second path upon introducing the wastewater into the treatment tank through the first path, and which performs pH value measurement and adjustment while circulating the first treated water through the third path until the first treated water is turned into a second treated water having a pH value within a desired range; a fourth path for transferring the second treated water; a reaction tank for generating calcium fluoride by adding calcium components to the second treated water; and a separation tank for separating the calcium fluoride from the second treated water.

Moreover, the pH adjustment unit includes a pH meter connected to an inner part of the third path, and controls opening and closing of the third path on the basis of a value measured by the pH meter.

Moreover, the pH adjustment unit closes the third path and introduces the alkali chemical into the first treated water in the treatment tank when the value measured by the pH meter is less than a first pH value.

Moreover, the pH adjustment unit introduces the alkali chemical into the first treated water in the treatment tank while keeping the third path opened when the value measured by the pH meter is not less than the first pH value and less than a second pH value.

Moreover, the pH adjustment unit stores the second treated water in the treatment tank by closing the third path when the value measured by the pH meter is not less than the second pH value and not more than a third pH value.

Moreover, the pH adjustment unit introduces an acid solution into the first treated water in the treatment tank while keeping the third path opened when the value measured by the pH meter is more than a third pH value.

Moreover, the pH adjustment unit measures the pH value of the first treated water a predetermined time after the start of circulation of the first treated water.

Moreover, the pH adjustment unit uses the wastewater as the acid solution for pH adjustment of the first treated water. Moreover, the fourth path transfers all of the second treated water inside the pH adjustment unit to the reaction tank.

Moreover, the pH of the second treated water is from 8 to 10 inclusive.

Moreover, the separation tank is a filtration device immersed in the second treated water.

Furthermore, the second treated water is filtered by a self-forming film formed on a surface of the filtration device.

### BRIEF DESCRIPTION OF THE DRAWINGS

- Fig. 1: is a schematic diagram showing a hydrofluoric acid treatment apparatus according to an embodiment of the present invention.
- Fig. 2: is a flowchart showing a treatment method using the hydrofluoric acid treatment apparatus according to the embodiment of the present invention.
- Fig. 3: is a flowchart showing a pH adjustment method using the hydrofluoric acid treatment apparatus according to the embodiment of the present invention.
- Fig. 4: is a view showing a filter device applied to the hydrofluoric acid treatment apparatus according to the embodiment of the present invention.
- Fig. 5A: is a view showing operating principles of the filter device applied to the hydrofluoric acid treatment apparatus according to the embodiment of the present invention and
- Fig. 5B: is an enlarged view of a first filter.
- Fig. 6: is a characteristic diagram for explaining the hydrofluoric acid treatment apparatus according to the embodiment of the present invention.
- Fig. 7A: is a top view,
- Fig. 7B: is a front view and
- Fig. 7C: is a side view for explaining the hydrofluoric acid treatment apparatus according to the embodiment of the present invention.

### DETAILED DESCRIPTION OF THE INVENTION

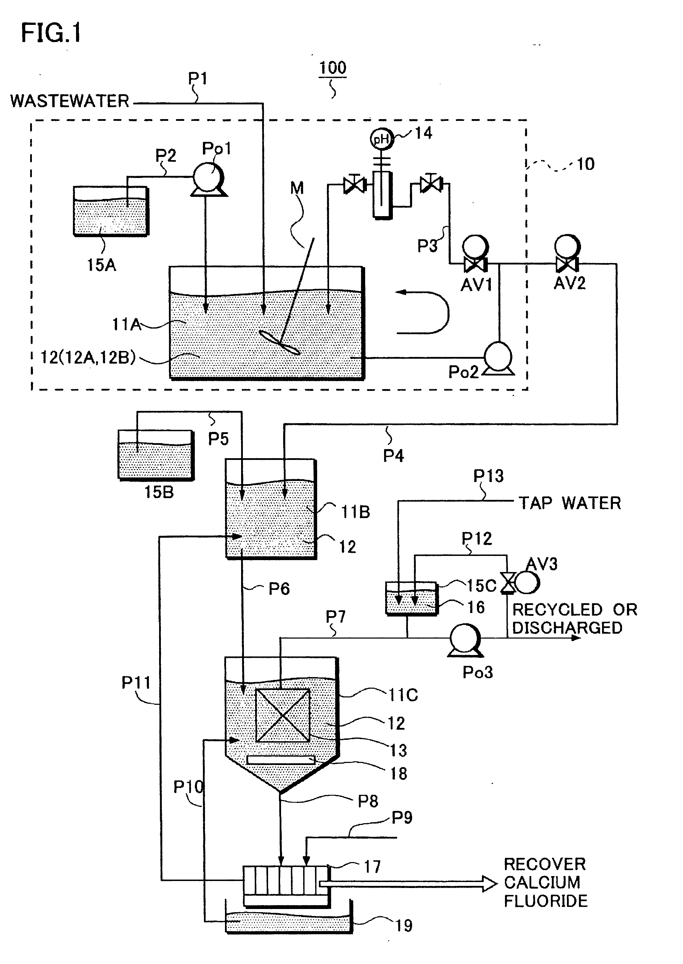

With reference to Figs. 1 to 7, description will be given of, as an embodiment of the present invention, a hydrofluoric acid treatment apparatus for treating wastewater containing hydrofluoric acid (hydrogen fluoride (HF) solution) and a hydrofluoric acid treatment method using the apparatus.

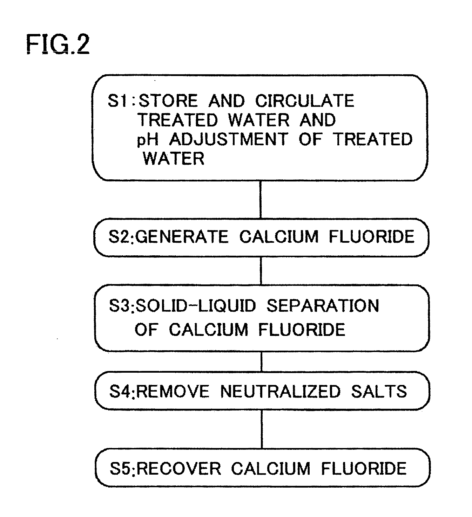

Fig. 1 is a view showing a configuration of a hydrofluoric acid treatment apparatus 100 and Fig. 2 is a flowchart showing a method for treating hydrofluoric-acid-containing wastewater.

With reference to Fig. 1, the configuration of the hydrofluoric acid treatment apparatus 100 will be described. The hydrofluoric acid treatment apparatus 100 of this embodiment includes a pH adjustment unit 10 having a first path P1, a second path P2, and a third path P3, a fourth path P4, a reaction tank 11B and a separation tank 11C. In a clean room, the apparatus is disposed close to a semiconductor processing apparatus using a fluorinated material. The apparatus treats hydrofluoric-acid-containing wastewater discharged from the semiconductor processing apparatus without carrying the wastewater out of the clean room.
The pH adjustment unit 10 includes a treatment tank 11A, a first path P1 and a second path P2, which are connected to the treatment tank 11A, and a third path P3 provided in the treatment tank 11A so as to circulate therethrough. Moreover, upon introducing the wastewater into the treatment tank 11A through the first path P1, the pH adjustment unit 10 previously introduces an alkali chemical from a chemical tank 15A to generate a first treated water 12A having a pH value larger than that of the wastewater. Furthermore, the pH adjustment unit 10 performs pH value measurement and adjustment while circulating the first treated water 12A through the third path P3 until the first treated water is turned into a second treated water 12B having a pH value within a desired range.

The reaction tank 11B generates calcium fluoride by adding calcium components to fluorine components contained in the second treated water 12B. The separation tank 11C separates the calcium fluoride from the second treated water 12B. The hydrofluoric acid treatment apparatus 100 thus configured can obtain high-purity calcium fluoride by removing fluoride ions from the hydrofluoric-acid-containing wastewater. First, the treated water 12 will be described. The treated water 12 is a collective term for the first treated water 12A and the second treated water 12B, which are treated by the hydrofluoric acid treatment apparatus 100 of this embodiment.

The first treated water 12A is a treated water obtained by mixing the wastewater introduced into the hydrofluoric acid treatment apparatus 100 with the alkali chemical. The second treated water 12B is a treated water obtained by adjusting the pH of the first treated water 12A until the pH value thereof reaches the pH value within the desired range. Specifically, the pH value of the second treated water 12B is from 8 to 10 inclusive and the first treated water 12A is the treated water having the pH value other than the above.

The wastewater introduced into the hydrofluoric acid treatment apparatus 100 is discharged from a semiconductor processing plant. For example, the wastewater is discharged as a result of etching of a semiconductor, glass, metal and the like; a wafer processing such as formation of a CVD film; or cleaning of the semiconductor processing apparatus.

For example, a dry (plasma) etching apparatus or a plasma CVD apparatus often uses fluorinated gases such as CF₄, C₂F₆ and C₄F₈. Moreover, those gases are also used for cleaning inside a chamber after wafer processing.

Most of the gases described above are discharged, as CF₄, to outside the chamber. However, since the gases contain a substance (Perfluorocompounds (PFCs) gas) that accelerates global warming, detoxification treatment is required. In this detoxification treatment, burned and decomposed fluorine is absorbed by water and thus dilute hydrofluoric acid wastewater is discharged. Moreover, a wet etching apparatus uses hydrofluoric acid to improve corrosiveness in etching. Thus, thick hydrofluoric acid wastewater that is a waste chemical after wafer processing or dilute hydrofluoric acid wastewater that is wastewater after pure water rinse is discharged.

Each of the components included in the hydrofluoric acid treatment apparatus 100 of this embodiment will be described in detail below.

The first path P1 is a channel such as a pipe, through which the hydrofluoric-acid-containing wastewater is transported to the treatment tank 11A without being carried out of the clean room. Here, the transportation of the wastewater in the state of being not carried out of the clean room in the hydrofluoric acid treatment apparatus 100 of this embodiment means approximately direct transportation of the wastewater from the semiconductor processing apparatus without carrying the wastewater out of the clean room. This excludes, for example, such a case as where the wastewater stored in the tank is transported to another facility from the clean room and then treated.

Meanwhile, the hydrofluoric acid treatment apparatus 100 does not have to be directly connected to the semiconductor processing apparatus as long as the apparatus is disposed in the clean room.

The hydrofluoric acid treatment apparatus 100 is disposed close to the semiconductor processing apparatus in a clean room of a semiconductor manufacturing plant. For example, the hydrofluoric-acid-containing wastewater, which is discharged from the semiconductor processing apparatus and is not required to be detoxified, is transported directly to the first path P1. Alternatively, the hydrofluoric-acid-containing wastewater is transported to the first path P1 after predetermined detoxification treatment is executed for PFCs gas discharged from the semiconductor processing apparatus. Note that, in order to control an amount of the wastewater to be transported to the hydrofluoric acid treatment apparatus 100, a storage tank of the wastewater may be provided at a pre-stage of the first path P1 or a pump may be interposed in the middle of the first path P1. The wastewater (about pH 3 to 4 in the case of the wastewater containing only hydrofluoric acid) to be fed through the first path P1 contains about 10,000 mg/L of fluoride ions (F⁻).

The second path P2 feeds the alkali chemical stored in the chemical tank 15A to the treatment tank 11A. Here, as the alkali chemical, a solution containing 25 wt% of NaOH, for example, is employed. A first pump Po1 is provided in the second path P2.

The third path P3 is a circulating path provided in the treatment tank 11A. Through the third path P3, the treated water 12 in the treatment tank 11A circulates to flow into the treatment tank 11A again. A pH meter 14 is provided in the middle of the third path P3 to measure the pH of the treated water 12 circulated through the third path P3. By providing the pH meter 14 in the third path P3, the treated water 12 (the first treated water 12A and the second treated water 12B) having pH larger than that of the wastewater flowing in through the first path P1 is measured. Thus, damage on the pH meter 14 can be avoided. Moreover, a second pump Po2 is provided in the third path. Furthermore, a first valve AV1 for opening and closing the third path P3 is provided in the third path P3.

In this embodiment, a predetermined amount of alkali chemicals are previously supplied to the treatment tank 11A through the second path P2 and the wastewater is supplied thereto through the first path P1 to generate the first treated water 12A.

In the treatment tank 11A, hydrogen fluoride (HF) in the wastewater is dissociated by 99.9% or more into hydrogen ions (H⁺) and fluoride ions (F⁻) (Formula A below).

HF → H⁺ + F⁻ (Formula A)

Moreover, in the treatment tank 11A, the treated water 12 may be stirred by stirring means M such as a propeller to accelerate the dissociation.

While circulating the first treated water 12A in the treatment tank 11A through the third path P3, the pH adjustment unit 10 supplies an acid solution through the first path P1 or supplies the alkali chemical through the second path P2 to make an adjustment such that the first treated water 12A is turned into the second treated water 12B having the pH value within the desired range. In this embodiment, as the acid solution for pH adjustment, the hydrofluoric-acid-containing wastewater supplied through the first path P1 is used. Thus, it is not required to separately provide a chemical tank of the acid solution. Consequently, cost reduction and miniaturization of the apparatus are realized.
To be more specific, since an acid solution tank for pH adjustment is not required, the hydrofluoric acid treatment apparatus 100 can be miniaturized to a size that allows arrangement of the apparatus in the clean room. Moreover, the apparatus can be disposed later in the existing clean room, particularly, close to the etching apparatus, the CVD apparatus or the like that discharges the wastewater. Thus, hydrofluoric acid treatment for removing fluorine from the hydrofluoric-acid-containing wastewater can be completed inside the clean room. Note that the pH adjustment unit 10 will be described in detail later.

The first valve AV1 is provided in the third path P3. When a water level in the treatment tank 11A is not lower than a predetermined lower limit, the first valve AV1 provided in the third path P3 that is the circulating path is opened. On the other hand, when the water level is not higher than the lower limit, the first valve AV1 is closed.

The fourth path P4 is a path through which the second treated water 12B, which is pH-adjusted in the treatment tank 11A, is transported to the reaction tank 11B for fixing the fluoride ions. A second valve AV2 is provided in the fourth path P4. By opening the second valve AV2, the second treated water 12B in the treatment tank 11A is transferred to the reaction tank 11B through the fourth path P4.

A fifth path P5 is a path for supplying calcium components to the reaction tank 11B from another chemical tank 15B. Specifically, for example, a calcium chloride (CaCl₂) solution (for example, 30 wt%) stored in the chemical tank 15B is supplied to the reaction tank 11B through the fifth path P5. By adding the calcium chloride, the fluoride ions, which are dissociated as shown in the above Formula A and which are contained in the second treated water 12B, are fixed as CaF₂ (calcium fluoride) (Formula B below).

Cₐ²⁺ + 2F⁻ → CaF₂ (Formula B)

The calcium chloride has a very high solubility product and thus can be supplied in large quantity into the treated water 12. For example, the calcium chloride is added to the second treated water 12B so as to obtain 200 mg/L or more of calcium ions (Ca²⁺). Thus, a concentration of the fluoride ions (F⁻) contained in the second treated water 12B can be set to 8 mg/L or less. This concentration of the fluoride ions satisfies a general effluent standard.

Furthermore, the calcium chloride stored in the reaction tank 11B may be introduced into the separation tank 11C for performing solid-liquid separation. Accordingly, the fluoride ions can be fixed also in the separation tank 11C. Thus, the fluoride ions contained in filtrate water can be further reduced.

Besides the calcium chloride described above, calcium hydroxide (Ca(OH)₂) may be added into the reaction tank 11B. The added calcium hydroxide functions as a seed crystal for fixing the fluoride ions. Thus, fixation of the fluoride ions can be accelerated.

Furthermore, in the reaction tank 11B, calcium fluoride particles can be increased in size to, for example, 0.25 µm or more by aging the treated water 12. Thus, there is an advantage that membrane separation of the calcium fluoride is facilitated. Moreover, the second treated water 12B treated in the reaction tank 11B is maintained to have the pH of 8 to 10. Thus, there is an advantage that no colloidal matter is generated and filtration is facilitated without having a filtration film obstructed in a subsequent step.

The second treated water 12B in this embodiment is required to have the pH set within the effluent standard (pH 5.8 to 8.6) for the wastewater. When the calcium fluoride is generated by use of the calcium chloride in the reaction tank 11B, hydrochloric acid is generated by Formula C below.

2HF + CaCl₂ → CaF₂ + 2HCl (Formula C)

Therefore, since the pH in the reaction tank 11B is lowered by 1 to 2, the pH of the second treated water 12B is adjusted to 8 to 10 in consideration thereof.

A sixth path P6 is a path for transporting the second treated water 12B containing the calcium fluoride from the reaction tank 11B to the separation tank 11C.

In the separation tank 11C, the calcium fluoride is separated from the second treated water 12B. Here, the calcium fluoride is separated from the second treated water 12B by filtration of a filtration film 13 immersed in the treated water 12 stored in the separation tank 11C.

The filtration film 13 is immersed in the second treated water 12B stored in the separation tank 11C and has a function of filtering the second treated water 12B. As the filtration film 13 to be employed, general filtration mechanisms capable of filtration in a fluid can be employed. In this embodiment, solid-liquid separation of the calcium fluoride and the second treated water 12B is performed by filtration using a self-forming film formed on a surface of the filtration film 13. This self-forming film will be described in detail later.

The self-forming film described above may be a self-forming film, made of a to-be-removed substance, containing the calcium fluoride generated in the second treated water 12B. Specifically, the second treated water 12B is filtered by the to-be-removed substance which is adsorbed to a filtering surface of the filtration film 13. Moreover, in recovery of the calcium fluoride, the self-forming film is also peeled off from the filtration film 13 and recovered.
An air diffuser 18 has a function of supplying air bubbles to the filtration film 13 from therebelow in the second treated water 12B. Specifically, gas is supplied to the air diffuser 18 by an unillustrated pump or the like provided outside to generate air bubbles. The air bubbles generated by the air diffuser 18 move upward along the filtering surface of the filtration film 13. As described above, by generating the air bubbles from the air diffuser 18, the self-forming film formed on the surface of the filtration film 13 can be set to have a certain thickness or less. This enables filtration of the second treated water 12B while preventing blockage of the pores of the self-forming film and securing a certain flux.

As the gas generated from the air diffuser 18, inert gas such as helium, neon, argon and nitrogen can be used. When air is supplied to the second treated water 12B from the air diffuser 18, there is a risk that a concentration of the calcium fluoride is lowered by reaction between carbon dioxide gas contained in the air and the fluoride ions contained in the second treated water 12B. The use of the inert gas as the gas to be supplied from the air diffuser 18 can eliminate such a risk.

A seventh path P7 is a path through which filtrate water filtered by the filtration film 13 passes. In a storage tank 15C provided in the middle of the seventh path P7, filtrate water 16 is stored. Most of the filtrate water passing through the seventh path P7 is recycled or discharged into nature.

The storage tank 15C stores some of the filtrate water filtered by the filtration film 13 or stores tap water supplied through a thirteenth path P13. A position of the storage tank 15C is set above a level of the second treated water 12B stored in the separation tank 11C. The filtrate water or the tap water stored in the storage tank 15C is allowed to flow backward through the seventh path P7 when the self-forming film formed on the surface of the filtration film 13 is peeled off.

Specifically, the apparatus includes a twelfth path P12 which is branched off from the seventh path P7 and which supplies the filtrate water to the storage tank 15C and a third valve AV3 provided in the middle of the twelfth path P12. Moreover, a third pump Po3 is provided in the seventh path P7.

In recycling or discharging the filtrate water in the separation tank 11C, the filtrate water is sucked up by the third pump Po3 and discharged to the outside by closing the third valve AV3.

Meanwhile, in the case of backward flow, the filtrate water in the separation tank 11C is sucked up by the third pump Po3 and stored in the storage tank 15C by opening the third valve AV3. Alternatively, the tap water is stored in the storage tank 15C through the thirteenth path P13. The filtrate water or the tap water in the storage tank 15C is allowed to flow backward into the separation tank 11C to peel off the self-forming film from the filtration film 13.
An eighth path P8 is a path for transporting the to-be-removed substance containing solidified calcium fluoride to a filter press 17 from the separation tank 11C. Specifically, the to-be-removed substance deposited on the surface of the filtration film 13 and the to-be-removed substance precipitated at the bottom of the separation tank 11C are transported to the filter press 17. The second treated water 12B to be transported contains high-purity calcium fluoride and also contains neutralized salts formed with the pH adjustment performed by the pH adjustment unit 10.
The to-be-removed substance containing the calcium fluoride is supplied to the filter press 17 through the eighth path P8, and a water content of the to-be-removed substance is reduced by dehydration. The water content of the to-be-removed substance dehydrated by the filter press 17 is, for example, about 50 wt%. Furthermore, a block containing the calcium fluoride with a purity of about 85 wt% is obtained by drying the to-be-removed substance. The high-purity calcium fluoride contained in the to-be-removed substance is reused as a fluorine source.

A ninth path P9 is a path for injecting water into the filter press 17 and cleaning the neutralized salts contained in the to-be-removed substance stored in the filter press 17. The to-be-removed substance in the second treated water 12B, which is pH-adjusted in the treatment tank 11A, contains about 15 wt% of neutralized salts (NaCl). By injecting the water into the filter press 17 through the ninth path P9, most of the neutralized salts are discharged to the outside from the filter press 17. Moreover, the calcium fluoride having a size larger than that of the neutralized salts remains in the filter press 17.

Specifically, the injection of the water into the filter press 17 can improve the purity of the calcium fluoride contained in the to-be-removed substance stored in the filter press 17.

In a receiving tank 19, the water injected into the filter press 17 is temporarily stored. The second treated water 12B stored in the receiving tank 19 is transported back to the separation tank 11C through a tenth path P10 and then filtered.

An eleventh path P11 is a path for transporting the to-be-removed substance dehydrated by the filter press 17 to the reaction tank 11B for generating calcium fluoride. In the filter press 17, a to-be-removed substance deposited on a surface of a filtration film 18 is stored. This to-be-removed substance contains high concentrations of calcium fluoride. Therefore, the to-be-removed substance mainly made of the calcium fluoride is transported back to the reaction tank 11B to accelerate the chemical reaction in the reaction tank 11B. Thus, most of the fluoride ions contained in the second treated water 12B can be fixed as the calcium fluoride.

The hydrofluoric acid treatment apparatus 100 of this embodiment has the configuration described above. Here, the reaction tank 11B and the separation tank 11C described above may be set as the same treatment tank. Accordingly, the fixation of the fluoride ions and the solid-liquid separation can be performed in the same tank. Thus, the whole apparatus can be further miniaturized.

With reference to Fig. 2, description will be given of a hydrofluoric acid treatment method using the hydrofluoric acid treatment apparatus 100 described above. The hydrofluoric acid treatment method of this embodiment includes: a first step (Step S1) of generating a first treated water by use of hydrofluoric acid wastewater and alkali chemicals and of generating a second treated water by adjusting pH of the first treated water; a second step (Step S2) of generating calcium fluoride; a third step (Step S3) of performing solid-liquid separation of the calcium fluoride; a fourth step (Step S4) of removing neutralized salts from a to-be-removed substance; and a fifth step (Step S5) of recovering the calcium fluoride. With reference to Fig. 2 together with Fig. 1, each of the steps will be described in detail.

Step S1: generating a first treated water by storing hydrofluoric acid wastewater and alkali chemicals and then generating a second treated water by adjusting pH of the first treated water while circulating the first treated water. First, a predetermined amount of alkali chemicals (NaOH) are stored in the treatment tank 11A. Moreover, hydrofluoric-acid-containing wastewater discharged from a semiconductor processing apparatus (for example, an etching apparatus, a CVD apparatus or the like) is stored in the treatment tank 11A. Here, pH of the hydrofluoric acid is about 4. By mixing the alkali chemicals with the wastewater, a first treated water 12A having pH larger than that of the wastewater is generated.

The first treated water 12A stored in the treatment tank 11A is circulated through a circulating path that is a third path P3, and a pH value thereof is measured by a pH meter 14 provided in the circulating path. Accordingly, pH adjustment is performed while circulating the first treated water 12A until the first treated water 12A is turned into a second treated water 12B having pH of 8 to 10.

As the alkali chemicals for the pH adjustment, NaOH is used as described above. However, KOH can be employed other than the above. Meanwhile, as an acid solution for the pH adjustment, hydrofluoric-acid-containing wastewater supplied through a first path P1 is used.

After the second treated water having a pH value within a desired range (pH 8 to 10) is generated by pH adjustment, circulation through the third path P3 is stopped. Thereafter, the second treated water 12B in the treatment tank 11A is transferred to a reaction tank 11B through a fourth path. Note that the flow of Step S1 (treatment by a pH adjustment unit 10) will be described in detail later.

Step S2: generating calcium fluoride by adding calcium components to the second treated water 12B containing fluoride ions and fixing the fluoride ions.

The second treated water 12B contains the fluoride ions and neutralized salts (NaCl). The calcium components to be added are, for example, calcium salts such as calcium chloride (CaCl₂) and calcium hydroxide (Ca(OH)₂). Here, a calcium chloride solution (for example, 30 wt%) is used. Even if the second treated water 12B contains a large quantity of the fluoride ions, the calcium chloride can be added in large quantity to the second treated water 12B because of a high solubility of the calcium chloride. Thus, most of the fluoride ions contained can be fixed. The second treated water 12B having the fluoride ions fixed as calcium fluoride is transported to a separation tank 11C.

Step S3: performing filtration to separate a to-be-removed substance containing calcium fluoride from the second treated water 12B.
As a mechanism for filtration, in this embodiment, a self-forming film is employed, which is made of a to-be-removed substance deposited on a surface of a filtration film 13. Filtrate water filtered by the filtration film 13 is discharged to the outside to be recycled or is discharged into nature. In the filtration method using the self-forming film, a flux of the self-forming film is gradually reduced. Thus, the self-forming film is regularly peeled off and formed again.

In peeling off the self-forming film, the filtrate water is allowed to flow backward to the filtration film 13 from a storage tank 15C. Specifically, the filtrate water or tap water in the storage tank 15C is sucked up by a third pump Po3 and allowed to flow backward into the separation tank 11C. Thus, the self-forming film is peeled off from the filtration film 13. Accordingly, the self-forming film deposited on the surface of the filtration film 13 is peeled off and precipitated at the bottom of the separation tank 11C.

Moreover, while filtering the second treated water 12B by use of the filtration film 13, air bubbles are allowed to pass through the surface of the filtration film 13 by an air diffuser 18. Thus, filtration performance can be maintained by controlling a thickness of the self-forming film formed on the surface of the filtration film 13. The to-be-removed substance concentrated by this step is transported to a filter press 17.

Step S4: cleaning and removing neutralized salts (NaCl) contained in the second treated water 12B by injecting water into the filter press 17.

The second treated water 12B subjected to the pH adjustment contains the neutralized salts. Therefore, the to-be-removed substance separated from the second treated water 12B also contains the neutralized salts or other calcium salts (for example, calcium carbonate) besides the calcium fluoride. Moreover, for example, wastewater from a wet etching apparatus may contain silicon. By injecting water into the filter press 17, the neutralized salts are dissolved in the water and discharged to the outside. Due to its large diameter, the calcium fluoride is not discharged to the outside from the filter press 17 even when cleaned by the water. This step improves a concentration of the calcium fluoride contained in the to-be-removed substance.

Step S5: recovering the calcium fluoride.

Specifically, after the to-be-removed substance is dehydrated by the filter press 17, the to-be-removed substance in a semi-solidified state is retrieved. In this state, a water content of the to-be-removed substance is set to about 50 wt%. Next, the to-be-removed substance is dried to form a block of the solidified to-be-removed substance. In this embodiment, the to-be-removed substance containing 85 wt% of the calcium fluoride is obtained.

In this embodiment, solid-liquid separation is performed without using a coagulant such as a polymer coagulant. Thus, fixed calcium fluoride can be obtained in high purity from the wastewater containing the fluoride ions. The calcium fluoride obtained is allowed to react with strong acid (for example, sulfuric acid) and thus can be reused as hydrofluoric acid in a semiconductor manufacturing process.

Furthermore, the high-purity calcium fluoride obtained in the present application can also be used as a flux to be mixed in steel. Moreover, calcium chloride can also be obtained by adding hydrochloric acid to the calcium fluoride obtained. Since sulfuric acid, hydrochloric acid and the like to be added to reuse the calcium fluoride are chemicals kept in a semiconductor plant, the calcium fluoride can be reused without adding new facility in the plant.

Furthermore, in this embodiment, after the pH adjustment of the treated water 12 is performed by use of NaOH or the like, the fluoride ions are fixed by the calcium chloride (CaCl₂). Therefore, most of the calcium components to be added react with the fluoride ions contained in the treated water. Thus, a proportion of the calcium fluoride to the to-be-removed substance can be improved.

Moreover, the neutralized salts generated by pH adjustment are removed by wash treatment. This also contributes to improvement in the purity of the calcium fluoride relative to the to-be-removed substance.

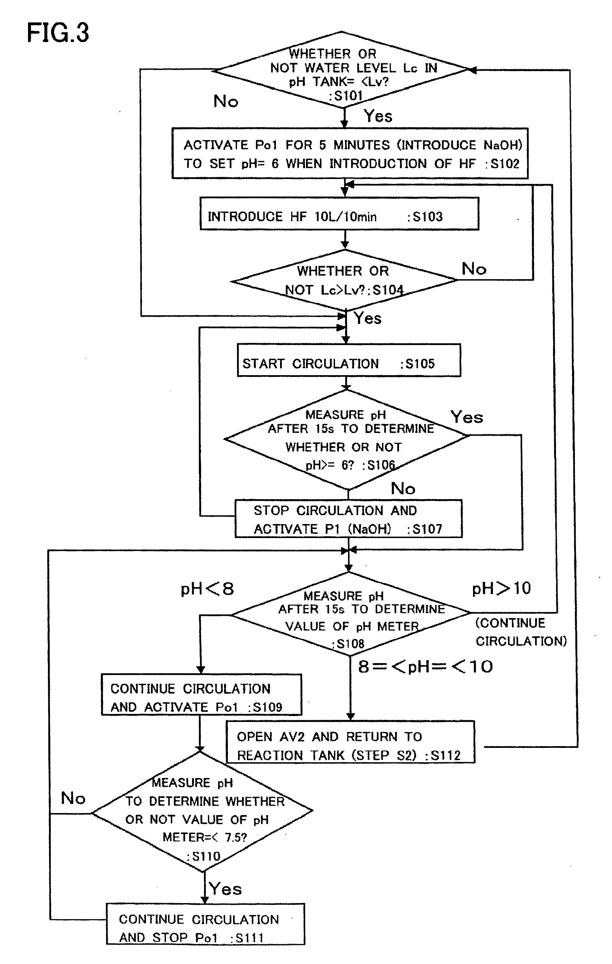

Fig. 3 is a flowchart showing details of the treatment by the pH adjustment unit 10 described in Step S1 shown in Fig. 2.

A pH adjustment method by the pH adjustment unit 10 includes: a step of introducing alkali chemicals and wastewater into the treatment tank 11A to generate the first treated water 12A having a pH value larger than that of the wastewater (Steps S101 to S104); a step of performing pH adjustment of the first treated water 12A by measuring pH thereof while circulating the first treated water 12A through the treatment tank 11A and the third path P3 (Steps S103 to S108); and a step of generating the second treated water 12B having a pH value within a desired range by pH adjustment, stopping circulation of the second treated water 12B, and transferring the second treated water to the reaction tank 11B through the fourth path P4 (Steps S108 to S112).

### Step S101: determining a water level Lc in the treatment tank 11A.

Immediately after the treatment in the pH adjustment unit 10 is started or after all of the second treated water 12B after the pH adjustment is transferred to the reaction tank 11B at the next stage, no more treated water is stored in the treatment tank 11A or a water level thereof is below a predetermined water level Lv. In this embodiment, the alkali chemicals are introduced into the treatment tank 11A before the hydrofluoric-acid-containing wastewater is introduced into the treatment tank 11A. Thus, first, the water level Lc in the treatment tank 11A is determined. If Lc is below the predetermined water level Lv, a predetermined amount of alkali chemicals are introduced in the next step. On the other hand, if Lc exceeds the predetermined water level Lv, a process of Step S105 is executed.

Step S102: introducing the alkali chemicals by activating a first pump Po1.

The first pump Po1 is activated for 5 minutes, for example. Thus, a predetermined amount of NaOH is introduced into the treatment tank 11A from the chemical tank 15A through the second path P2. NaOH has pH 7.3 and is introduced into the treatment tank 11A by estimating an amount that allows the treated water (the first treated water) in the treatment tank 11A to have pH of 6 when a predetermined amount of wastewater (pH 4) is introduced into the treatment tank 11A in the subsequent Step S103.

Here, the pH of the wastewater to be introduced in the subsequent Step S103 is not necessarily a constant value (pH 4). Moreover, the amount of the wastewater to be introduced may be less than the predetermined amount depending on a timing at which the wastewater is discharged from the semiconductor processing apparatus. Therefore, the pH value and the amount of the wastewater are set to be adjusted in the subsequent step. Here, the introduction amount is determined as an initial predicted value.

Step S103: introducing hydrofluoric-acid-containing wastewater.

A predetermined amount of wastewater discharged from the semiconductor processing apparatus is introduced into the treatment tank 11A through the first path P1 without being carried out of the clean room. As to the predetermined amount, for example, the wastewater is intermittently introduced by 10L/ 10 min.

The wastewater contains hydrofluoric acid and has the pH of about 4. The alkali chemicals are previously introduced into the treatment tank 11A (Step S102) and thus the first treated water 12A having the pH larger than that of the introduced wastewater is generated.

Note that the pH of the wastewater is not necessarily a constant value. Moreover, the amount of the wastewater to be introduced into the treatment tank 11A may be less than 10L even after introduction thereof for 10 minutes depending on the timing at which the wastewater is discharged from the semiconductor processing apparatus.

Step S104: determining the water level in the treatment tank 11A.

It is determined whether or not the water level Lc of the first treated water 12A in the treatment tank 11A has reached the predetermined water level Lv. If Lc has not reached Lv (not enough wastewater has been introduced), the hydrofluoric-acid-containing wastewater is introduced again in Step S103.

If the water level Lc of the first treated water 12A has reached the predetermined water level Lv, circulation is started in the next Step S105.

Step S105: starting circulation of the treated water 12.

The treated water is sucked up by the second pump Po2 by opening the first valve AV1 in the third path P3 that is the circulating path and by closing the second valve AV2 in the fourth path P4. Accordingly, the first treated water 12A in the treatment tank 11A is circulated. The first treated water 12A passes through the third path P3 and flows into the treatment tank 11A again.

Step S106: measuring the pH value of the treated water 12 .

After the circulation for a predetermined period of time (for example, 15 seconds), the pH value of the first treated water 12A passing through the third path P3 is measured by the pH meter 14 provided in the third path P3. Although the pH meter 14 is in constant contact with the treated water 12 (the first treated water 12A), the pH value is measured after a lapse of the predetermined time in order to stabilize the pH of the first treated water 12A.

When the pH value is 6 or more, a process of Step S108 is executed to further adjust the pH of the treated water to a desired pH (alkaline). On the other hand, when the pH value is 6 or less, a process of Step S107 for stopping the circulation is executed.

In this embodiment, after the step of introducing the wastewater (Step S103), the circulation is started when the water level Lc in the treatment tank 11A has reached the predetermined water level Lv. In other words, the circulation is started after it is determined that the predetermined amount of alkali chemicals (or the first treated water 12A more alkaline than the wastewater) exist in the treatment tank 11A. Therefore, the pH meter 14 provided in the circulating path constantly measures the treated water having the pH larger than that of the wastewater. Specifically, the pH meter 14 never comes into direct contact with the hydrofluoric acid. Thus, a sensor can be prevented from being broken by melting of glass of the pH meter.

Moreover, after the introduction of the wastewater and the alkali chemicals, the treated water is circulated for 15 seconds and then the pH value is measured. Thus, the pH of the first treated water 12A can be stabilized.

Step S107: stopping the circulation of the first treated water 12A and adding the alkali chemicals by activating the first pump Po1.

The pH less than 6 (but larger than that of the wastewater) leads to a state too acidic for the pH meter 14. Therefore, the second pump Po2 connected to the third path P3 is stopped (the first valve AV1 is opened) and the circulation of the acidic first treated water 12A is stopped.

Thereafter, the first pump Po1 provided in the second path P2 is activated for a certain period of time (for example, 10 seconds) to introduce a certain amount of alkali chemicals into the treatment tank 11A. Subsequently, the circulation is restarted in Step S105 and then the pH value after a lapse of predetermined time is measured in Step S106.

In this step, the alkali chemicals are introduced by a predetermined amount at a time. Moreover, Steps S105 to S107 are repeated until the pH of the first treated water 12A becomes 6 or more.

In order to avoid an adverse effect such as melting of the glass of the pH meter 14, the pH is preferably about 6. However, the first treated water 12A immediately after the start of the treatment may have the pH less than 6 as described above. However, if the pH is less than 6, the alkali chemicals are further added in this step after the circulation is stopped. Accordingly, the first treated water 12A is gradually shifted to alkaline. Thus, there is no problem.

Step S108: measuring the pH of the first treated water 12A and determining whether or not the pH takes a pH value within a predetermined range.

In Step S106, when the pH value of the first treated water 12A is 6 or more, it is determined whether or not the pH value is within a desired range (pH 8 to pH 10). If the pH is less than 8, a process of Step S109 is executed to add the alkali chemicals. On the other hand, if the pH is more than 10, the process of Step S103 is executed to add the acid solution.

Step S109: adding the alkali chemicals.

When the pH value of the first treated water 12A is equal to or more than 6 and less than 8, the alkali chemicals are further added to generate the second treated water 12B.

While continuing the circulation of the first treated water 12A, the first pump Po1 in the second path P2 is activated to add the alkali chemicals.

Step S110: measuring the pH value of the first treated water 12A.

After the addition of the alkali chemicals in Step S109, the pH value is measured again by the pH meter 14. When the pH is set closer to 8 (for example, pH 7.5), the first pump Po1 is stopped in Step S111. The pH meter 14 is provided in the middle of the circulating path (the third path P3). This is because the pH measurement here is not for measuring the pH of the treated water 12 (the second treated water 12B) in the treatment tank 11A, the treated water having the alkali chemicals added thereto in Step S109, but for measuring the pH value of the first treated water 12A remaining in the circulating path.

When the pH is less than 7.5, the pH value is measured in Step S108 while keeping the first pump Po1 activated (while continuing the introduction of the alkali chemicals).
Step S111: stopping the first pump Po1.

If the pH of the treated water in the third path P3 is increased to, for example, 7.5 with the alkali chemicals added in Step S109, the pH value of the first treated water 12A after circulation for a predetermined period of time (15 seconds) may be within a desired pH value range even if no more alkali chemicals are added. Therefore, the first pump Po1 is stopped once (addition of the alkali chemicals is stopped) and the pH value is measured in Step S108.
Step S112: discharging the second treated water 12B to the reaction tank 11B by opening the second valve AV2.
When the treated water 12 in the treatment tank 11A has a pH value within a desired range, the second treated water 12B is generated and all the second treated water 12B is transferred to the reaction tank 11B by opening the second valve AV2 in the fourth path P4. Thus, the water level Lc in the treatment tank 11A is lowered. Thereafter, the processes are repeated from Step S101. Note that the circulation is not stopped even while transferring the second treated water 12B to the reaction tank 11B by opening the second valve AV2. This is because of the following. Specifically, there is a case where the pH of the treated water 12 in the treatment tank 11A is changed (for example, a case where the wastewater is supplied during the transfer of the treated water to the reaction tank 11B). Thus, it is required to constantly monitor the pH.

Here, the second treated water 12B has the pH of 8 to 10 after being circulated for a predetermined period of time (15 seconds) in Step S106. Through these steps (Steps S106 and S108), the pH of the second treated water 12B to be supplied to the reaction tank 11B can be stabilized.

The second treated water 12B after this step is treated according to the flow of processes after Step S2 shown in Fig. 2.

As described above, in this embodiment, the second treated water 12B having the pH stabilized is generated, the pH being adjusted to 8 to 10 by the pH adjustment unit 10, and then transferred to the reaction tank 11B. Thus, the second treated water 12B can be allowed to react with calcium.

As described above, in order to obtain calcium fluoride by reacting hydrofluoric acid with calcium, it is required to dissociate the hydrofluoric acid (HF) to obtain fluoride ions (F⁻). However, proportions of the hydrofluoric acid and the fluoride ions depend on the pH and the hydrofluoric acid takes up a major proportion in an acidic state. Thus, treatment efficiency is deteriorated. In this embodiment, the pH of the second treated water 12B containing the hydrofluoric acid can be set to 8 to 10 before reaction with calcium. Thus, the treatment efficiency can be improved.

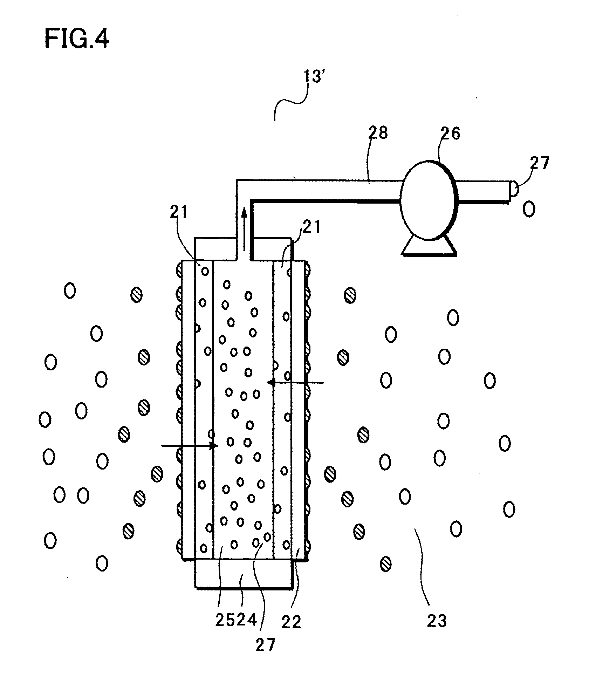

Next, with reference to Fig. 4, detailed description will be given of a filtration mechanism (a filter device 13') that can be applied as the filtration film 13 immersed in the second treated water 12B. The following description is given of a configuration of the filtration mechanism using a self-forming film. However, filtration devices having other configurations can also be applied to the present invention.

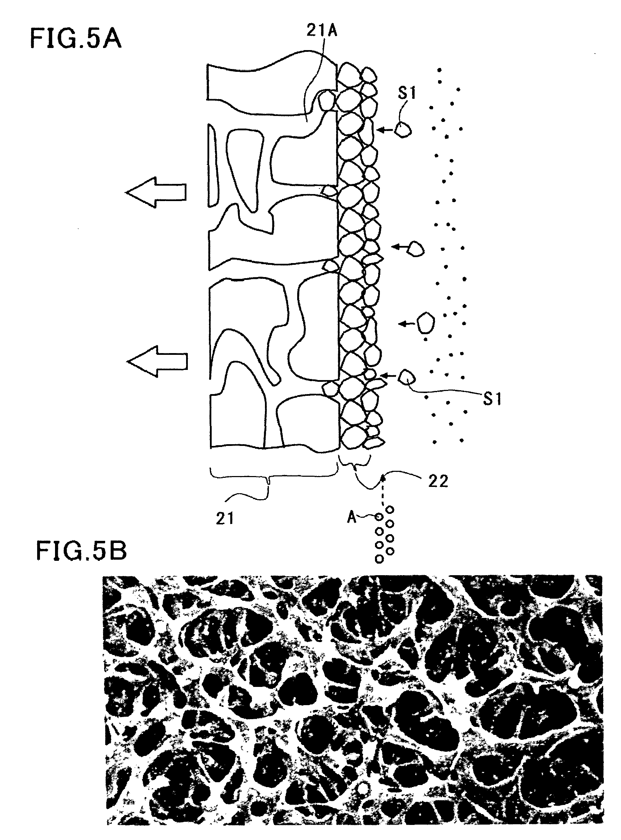

With reference to Figs. 4 and 5, the filtration mechanism as the filtration film 13 of this embodiment uses a filter made of a self-forming film formed of a to-be-removed substance to remove a fluid (the second treated water 12B) mixed with a to-be-removed substance that is calcium fluoride.

To be more specific, in the filter device 13' of this embodiment, a self-forming film to serve as a second filter 22 formed of calcium fluoride that is the to-be-removed substance is formed on a surface of a first filter 21 made of an organic polymer. The treated water containing the to-be-removed substance is filtered by use of the second filter 22 that is the self-forming film.

As the first filter 21, an organic polymer material or a ceramic material can be employed in principle as long as the filter can allow the self-forming film to adhere thereto. Here, a polyolefin polymer film having an average pore size of 0.25 µm and a thickness of 0.1 mm is employed. Fig. 5B shows a photograph of a surface of a filter film made of the polyolefin polymer film.

Moreover, the first filter 21 has a flat film structure provided on both sides of a frame 24 and is immersed upright in the fluid. A filtrate 27 can be taken out by using a pump 26 to suck the filtrate from a hollow part 25 of the frame 24.

Next, the second filter 22 is the self-forming film which is attached to the entire surface of the first filter 21 and is solidified by sucking aggregated particles of the to-be-removed substance. This self-forming film may be formed by aggregating the particles into a gel or cake form.

Next, description will be given of formation of the second filter 22 that is the self-forming film made of the to-be-removed substance described above and of filtration for removing the to-be-removed substance. The fluid (the second treated water 12B) containing the calcium fluoride is diffused in a particulate state in the second treated water 12B.

With reference to Fig. 5A, the first filter 21 has a number of filter pores 21A, and the self-forming film made of the to-be-removed substance is the second filter 22. Specifically, the self-forming film is formed into a layer on openings of the filter pores 21A and on the surface of the first filter 21. On the surface of the first filter 21, there are aggregated particles of the to-be-removed substance made of calcium fluoride. These aggregated particles are sucked through the first filter 21 by a suction pressure from the pump. Since the moisture content of the fluid is sucked up, the aggregated particles are dried (dehydrated) and quickly solidified. Thus, the second filter 22 is formed on the surface of the first filter 21.

Since the second filter 22 is formed of the aggregated particles of the to-be-removed substance, the filter is immediately set to have a predetermined thickness. Thereafter, filtration of the aggregated particles of the to-be-removed substance is started by use of the second filter 22. Therefore, when the filtration is continued while sucking the particles by use of the pump 26 (see Fig. 4), the self-forming films of the aggregated particles are thickly stacked on the surface of the second filter 22. Eventually, the second filter 22 is clogged and the filtration can no longer be continued. Meanwhile, the calcium fluoride that is the to-be-removed substance adheres, while being solidified, to the surface of the second filter 22 and the treated water passes through the first filter 21 to be retrieved as filtrate water.

In Fig. 5A, the treated water containing the to-be-removed substance is on one side of the first filter 21 and the filtrate water passing through the first filter 21 is generated on the other side of the first filter 21. The treated water is sucked and flows in a direction indicated by the arrows. This sucking allows the aggregated particles in the second treated water 12B to approach the first filter 21 and to be solidified. Furthermore, a self-forming film formed of some of the aggregated particles bonded is adsorbed onto the surface of the first filter 21. Thus, the second filter 22 is formed. The treated water is filtered while the second filter 22 solidifies the to-be-removed substance in the solution.

By slowly sucking the treated water that is the solution through the second filter 22 as described above, the water in the treated water can be retrieved as the filtrate water. Moreover, the to-be-removed substance is dried and solidified to be stacked on the surface of the second filter 22. The aggregated particles of the to-be-removed substance are trapped as the self-forming film.

The first filter 21 is immersed upright in the treated water and the to-be-removed substance is dispersed in the treated water. When the treated water is sucked up by a weak suction pressure from the pump 26 through the first filter 21, the aggregated particles of the to-be-removed substance are bonded to each other on the surface of the first filter 21 and are adsorbed onto the surface of the first filter 21. Note that aggregated particles S1 having a diameter smaller than that of the filter pores 21A pass through the first filter 21. This does not cause a problem since the filtrate water is circulated into the treated water again in the process of forming the second filter 22.

In this film formation process, since the treated water is sucked by a very weak suction pressure, the aggregated particles S1 are stacked while forming gaps in various shapes. Accordingly, a soft self-forming film with a very high degree of swelling is formed to serve as the second filter 22. The water in the treated water is sucked while passing through the self-forming film with the high degree of swelling and then is retrieved as the filtrate water after passing through the first filter 21. Thus, the treated water is finally filtered.

Moreover, by sending air bubbles A from the bottom of the treated water (the air diffuser 18 shown in Fig. 1), a parallel flow is formed in the treated water along the surface of the first filter 21. This is for allowing the second filter 22 to evenly adhere to the entire surface of the first filter 21 and for allowing the second filter 22 to flexibly adhere thereto by forming gaps in the second filter 22. Specifically, an air flow rate is set to 1.8 liter/ minute but is selected on the basis of film quality of the second filter 22.

Next, in the filtration process, the aggregated particles S1 made of calcium fluoride are gradually stacked on the surface of the second filter 22 while being adsorbed thereto by the weak suction pressure. In this event, purified water passes through the second filter 22 and the aggregated particles S1 further stacked, and is retrieved as the filtrate water from the first filter 21.

However, when the filtration is continued for a long period of time, the self-forming films thickly adhere to the surface of the second filter 22. Thus, the gaps described above are eventually clogged. As a result, the filtrate water can no longer be retrieved. Therefore, for recovering the filtration performance, it is required to remove the self-forming films stacked.

The following is an example of recovery of the filtration performance.

For example, the hollow part 25 inside the first filter 21 has a negative pressure compared with the outside due to the weak suction pressure. Thus, the first filter 21 has a shape recessed inward. Therefore, the second filter 22 adsorbed onto the surface thereof also has a shape recessed inward. Furthermore, the self-forming film gradually adsorbed onto the surface of the second filter 22 also has the same shape.

In the recovery process, the pressure is restored approximately to the atmospheric pressure by stopping the weak suction pressure. Thus, the first filter 21 is restored to its original state. Accordingly, the second filter 22 and the self-forming film adsorbed onto the surface thereof are also restored to their original states. As a result, since the suction pressure adsorbing the self-forming film is eliminated, the self-forming film loses its adsorption power to the filter device 13' and receives force to swell outward. Thus, the adsorbed self-forming film starts to be separated under its own weight.

Furthermore, when the filtrate water is allowed to flow backward through the hollow part 25 in the recovery process, the backward flow helps restoration of the first filter 21 to its original state. Moreover, a hydrostatic pressure of the filtrate water is applied to generate force to further swell outward. Furthermore, the filtrate water seeps out to a boundary between the first and second filters 21 and 22 from the inside of the first filter 21 through the filter pores 21A. The filtrate water that has seeped out facilitates separation of the self-forming film as the second filter 22 from the surface of the first filter 21. The backward flow described above can be generated by allowing the filtrate water 16 temporarily stored in the storage tank 15C shown in Fig. 1 to flow into the filtration film.

When the filtration is continued while reproducing the second filter 22 as described above, the concentration of the to-be-removed substance in the second treated water 12B is increased and viscosity of the second treated water 12B is also eventually increased. Therefore, when the concentration of the to-be-removed substance in the second treated water 12B exceeds a predetermined concentration, the filtration operation is stopped and the treated water is left for precipitation. Thereafter, concentrated slurry is deposited at the bottom of the separation tank 11C. This concentrated slurry in a cake form is recovered. The recovered concentrated slurry is compressed or thermally dried to remove water contained therein, thereby further reducing the volume thereof.

The slurry can be reused as a hydrofluoric acid source. Specifically, formation, separation and deposition of the self-forming film are repeated by allowing backward flow of the filtrate water 16 stored in the storage tank 15C or the tap water to be supplied to the storage tank 15C. Thus, concentration efficiency of the concentrated slurry to be a raw material of hydrofluoric acid can be improved.

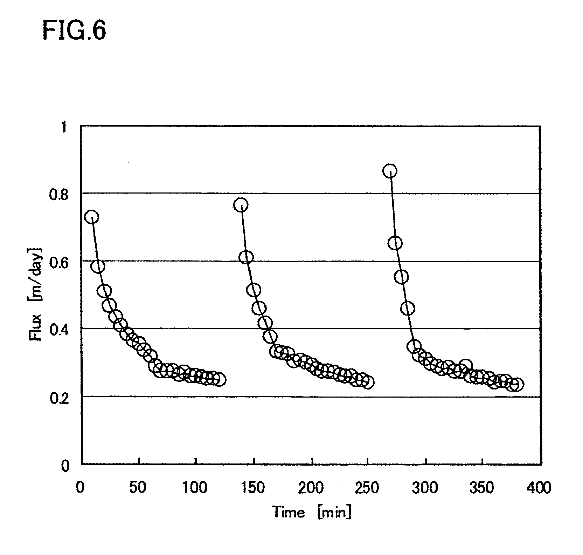

With reference to Fig. 6, description will be given of an experiment for filtration of the second treated water 12B by use of the filtration film 13 shown in Fig. 1. Fig. 6 is a graph showing a flux variation with time in filtration treatment. In this graph, the horizontal axis indicates time for which the treatment is continuously performed and the vertical axis indicates a size of the flux.

First, conditions of this experiment will be described. In this experiment, filtration is performed by applying a suction pressure of 7 kPa to a filtration film having an area of 0.1 m². In treated water, calcium chloride is added to wastewater containing 1000 mg/L of fluoride ions, and the fluoride ions are fixed as calcium fluoride. A diameter of the calcium fluoride is about 0.25 µm. The experiment is conducted by regularly measuring an amount of the treated water and the flux.

This experiment has proved that an average flux is 0.4 m/day and the filtration film 13 of this embodiment is sufficiently durable for practical use. Furthermore, a concentration of the fluoride ions contained in filtrate water obtained by the filtration film 13 is 3.5 mg/L, which satisfies a general effluent standard.

A method for the experiment will be described in detail. First, a self-forming film is formed on a surface of the filtration film by circulating a to-be-removed substance such as calcium fluoride. Thereafter, filtration is started when the filtrate water having a certain degree of clarity or more is obtained.

The flux upon start of the filtration is about 0.7 m/day. As the filtration is continued, the flux is gradually lowered. This is because blockage of the pores of the self-forming film proceeds with the course of the filtration. The flux at the time when 130 minutes have passed since the start of the filtration is about 0.2 m/day. At this point, the self-forming film is released from the filtration film and the to-be-removed substance concentrated in the treated water is recovered.

When release of the self-forming film and recovery of the to-be-removed substance are finished, a new self-forming film is formed on the surface of the filtration film and filtration of the treated water is performed again. By repeating the above processes, the to-be-removed substance containing calcium fluoride can be separated from the treated water.

The experiment described above shows that a sufficient flux can be secured by regularly releasing and reproducing the self-forming film.

In this embodiment, as described above, the solid-liquid separation of the calcium fluoride is performed by use of the filtration film 13. Therefore, if the wastewater is directly transported to the reaction tank 11B without performing pH adjustment of hydrofluoric acid contained in the wastewater, there causes a problem that the filtration film 13 is damaged since the pH of the wastewater is 3 to 4, which is outside an allowable range of pH for the filtration film 13.

However, in this embodiment, the second treated water 12B having its pH value adjusted to 8 to 10 is generated and then transported to the reaction tank 11B. Thus, the damage to the filtration film 13 can be prevented.

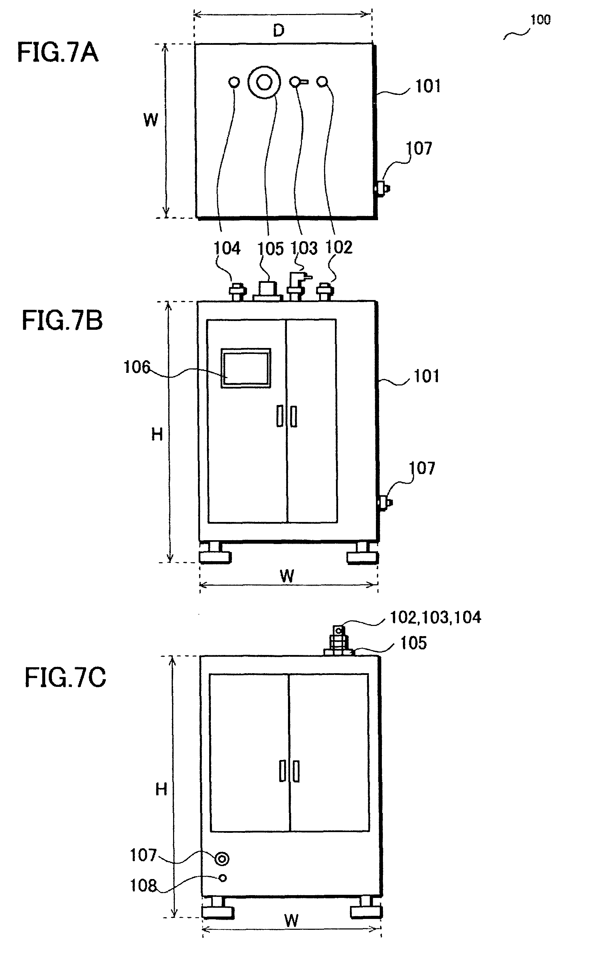

Fig. 7A is a top view, Fig. 7B is a front view and Fig. 7C is a side view showing an external appearance of the hydrofluoric acid treatment apparatus 100 according to this embodiment.

The hydrofluoric acid treatment apparatus 100 of this embodiment shown in Fig. 1 is housed in a housing 101 shown in Figs. 7A to 7C. Specifically, the hydrofluoric acid treatment apparatus 100 has a size that can be housed in the housing 101 having width W × depth D × height H of, for example, about 1140 mm × 1140 mm × 1800 mm.

On top of the housing 101, a wastewater receiving port 102 is provided, which is connected to the first path P1 inside the housing 101. Moreover, on top of the housing 101, provided are: a supplied water receiving port 103 connected to the ninth path P9 or the thirteenth path P13 inside the housing 101; a filtrate water port 104 for discharging the filtrate water; an exhaust port 105; and the like (Fig. 7A).

On a front surface of the housing 101, a display panel 106 for displaying information during treatment is provided (Fig. 7B). In a lower part of a side of the housing 101, a concentrate extraction port 107 for recovering the concentrated slurry to be the raw material of hydrofluoric acid and an air supply port 108 are provided (Fig. 7C).

As described above, the hydrofluoric acid treatment apparatus 100 of this embodiment is very small and thus can be disposed in the clean room. Particularly, even in the existing clean room, the apparatus can be disposed later close to the etching apparatus, the CVD apparatus or the like that discharges the wastewater.

Thus, hydrofluoric acid treatment for removing fluorine from the hydrofluoric-acid-containing wastewater can be completed inside the clean room.

According to the hydrofluoric acid treatment apparatus of this embodiment, first, in the hydrofluoric acid treatment apparatus for treating the hydrofluoric-acid-containing wastewater discharged from the semiconductor processing apparatus, the treated water (the second treated water) having a desired pH value can be generated by increasing the pH value of the wastewater in the pH adjustment unit before transportation of the wastewater to the reaction tank for reacting the wastewater with calcium. Thus, treatment efficiency can be improved.

As described above, in order to obtain calcium fluoride by reacting the hydrofluoric acid with calcium, it is required to dissociate the hydrofluoric acid to obtain fluoride ions (F⁻). However, proportions of the hydrofluoric acid and the fluoride ions depend on the pH. Specifically, when the treated water is acidic, the hydrofluoric acid takes up a major proportion. Thus, the treatment efficiency is deteriorated.

According to this embodiment, before reaction with calcium, the pH of the wastewater is adjusted to obtain a desired pH value (neutral). Consequently, the fluoride ions obtained from the dissociation can be increased and thus the treatment efficiency can be improved.

Secondly, by providing the third path in the treatment tank and providing the pH meter in the third path, the pH meter can be prevented from being damaged by the hydrofluoric acid. Since the pH meter generally uses a glass electrode, glass is melted when the pH meter directly measures the hydrofluoric acid solution. Thus, melting of glass damages a sensor.

In this embodiment, the third path is provided outside the treatment tank and the pH meter is provided in the third path. Furthermore, in the treatment tank, the hydrofluoric acid is mixed into the previously introduced alkali chemical to shift the pH value of the treated water into the treated water (the first treated water) having a value that causes no adverse effect on the pH meter (a value larger than the pH value of the wastewater). Thereafter, the treated water is circulated and the pH value is measured. Thus, the pH meter can be prevented from making direct contact with the hydrofluoric acid solution. As a result, the pH meter can be protected.

Third, after the pH adjustment, the treated water (the first treated water or the second treated water) is circulated for a predetermined period of time. Thereafter, the pH value of the treated water is measured. Thus, the pH can be adjusted in a stable state. Moreover, particularly, the stabilized pH of the second treated water enables efficient treatment in the next step (reaction with calcium).

Fourth, as the acid solution to be used for the pH adjustment, the hydrofluoric-acid-containing wastewater discharged from the semiconductor processing apparatus is used. Thus, it is not required to separately provide an acid solution and an acid solution tank. This can contribute to cost reduction and miniaturization of the hydrofluoric acid treatment apparatus.

Specifically, since no acid solution tank is required, the hydrofluoric acid treatment apparatus can be miniaturized to a size that allows arrangement of the apparatus in the clean room. Moreover, the apparatus can be disposed later in the existing clean room (particularly, close to an etching apparatus or the like that discharges the wastewater). Thus, hydrofluoric acid treatment for removing fluorine from the hydrofluoric-acid-containing wastewater can be completed inside the clean room.

Fifth, calcium fluoride is generated after the second treated water having a pH value within a range suitable for reaction with calcium is generated by the pH adjustment unit. Therefore, calcium components enough to fix the fluoride ions contained in the treated water can be added to the second treated water. Thus, a content of the calcium fluoride can be increased. Therefore, the calcium fluoride to be obtained can be easily reused. Furthermore, the fluoride ions can be efficiently removed from the treated water.

Sixth, the filtration film is used for solid-liquid separation of the calcium fluoride. Since the second treated water is adjusted to have the pH of 8 to 10 that is an allowable range of pH for the filtration film. Thus, the separation can be performed without damaging the filtration film.

## Claims

1. A hydrofluoric acid treatment apparatus which is disposed close to a semiconductor processing apparatus using a fluorinated material in a clean room and which treats hydrofluoric-acid-containing wastewater discharged from the semiconductor processing apparatus without carrying the wastewater out of the clean room, the apparatus comprising:
a pH adjustment unit which includes a treatment tank, first and second paths connected to the treatment tank and a third path provided in the treatment tank so as to have a circulating structure, which generates a first treated water having a pH value larger than that of the wastewater by introducing an alkali chemical through the second path upon introducing the wastewater into the treatment tank through the first path, and which performs pH value measurement and adjustment while circulating the first treated water through the third path until the first treated water is turned into a second treated water having a pH value within a desired range;
a fourth path for transferring the second treated water;
a reaction tank for generating calcium fluoride by adding calcium components to the second treated water; and
a separation tank for separating the calcium fluoride from the second treated water.

2. The hydrofluoric acid treatment apparatus according to claim 1, wherein the pH adjustment unit includes a pH meter connected to an inner part of the third path, and controls opening and closing of the third path on the basis of a value measured by the pH meter.

3. The hydrofluoric acid treatment apparatus according to claim 2, wherein the pH adjustment unit closes the third path and introduces the alkali chemical into the first treated water in the treatment tank when the value measured by the pH meter is less than a first pH value.

4. The hydrofluoric acid treatment apparatus according to claim 2, wherein the pH adjustment unit introduces the alkali chemical into the first treated water in the treatment tank while keeping the third path opened when the value measured by the pH meter is not less than the first pH value and less than a second pH value.

5. The hydrofluoric acid treatment apparatus according to claim 2, wherein the pH adjustment unit stores the second treated water in the treatment tank by closing the third path when the value measured by the pH meter is not less than the second pH value and not more than a third pH value.

6. The hydrofluoric acid treatment apparatus according to claim 2, wherein the pH adjustment unit introduces an acid solution into the first treated water in the treatment tank while keeping the third path opened when the value measured by the pH meter is more than a third pH value.

7. The hydrofluoric acid treatment apparatus according to claim 1, wherein the pH adjustment unit measures the pH value of the first treated water a predetermined time after the start of circulation of the first treated water.

8. The hydrofluoric acid treatment apparatus according to any one of claims 1 and 6, wherein the pH adjustment unit uses the wastewater as the acid solution for pH adjustment of the first treated water.

9. The hydrofluoric acid treatment apparatus according to any one of claims 1 and 5, wherein the fourth path transfers all of the second treated water inside the pH adjustment unit to the reaction tank.

10. The hydrofluoric acid treatment apparatus according to claim 1, wherein the pH of the second treated water is from 8 to 10 inclusive.

11. The hydrofluoric acid treatment apparatus according to claim 1, wherein the separation tank is a filtration device immersed in the second treated water.

12. The hydrofluoric acid treatment apparatus according to claim 11, wherein the second treated water is filtered by a self-forming film formed on a surface of the filtration device.
